# EUROPÄISCHE PATENTANMELDUNG

(11) **EP 0 778 467 A2**
(43) Veröffentlichungstag der Anmeldung: **11.06.1997**
(21) Anmeldenummer: 96119217.6
(22) Anmeldetag: 29.11.1996
(51) Int. Cl.: G01R 31/02, H02H 5/10

(54) **Schaltungsanordnung zur Erdungsüberwachung und zum Schutz vor gefährlichen Körperströmen, insbesondere für Geräte mit vorgeschriebenem Potentialausgleich in TT-Netzen**

(30) Priorität: 04.12.1995 DE 29519212 U
(71) Anmelder: SIEMENS AKTIENGESELLSCHAFT, 80333 München (DE)
(72) Erfinder: Beckers, Paul, 52399 Merzenich (DE)

(57) **Zusammenfassung**

Die Erfindung betrifft eine Schaltungsanordnung zur Erdungsüberwachung und zum Schutz vor gefährlichen Körperströmen, insbesondere für Geräte mit vorgeschriebenem Potentialausgleich in TT-Netzen, wobei ein Schutzleiter (PE) installationsseitig mit einem Nulleiter (N) elektrisch verbunden ist und der Potentialausgleich (PA) mit Erdpotential (E) verbunden ist. Desweiteren sind Kondensatoren (C1, C2) vorgesehen, welche zwischen dem Schutzleiter (PE) und dem Nulleiter (N) sowie zwischen dem Schutzleiter (PE) und einem Phasenleiter (L) so angeordnet sind, daß sie im Gefährdungsfall einen kapazitiven Spannungsteiler bilden. Es ist ein Überwachungsglied (N1) vorgesehen, das über den kapazitiven Spannungsteiler (C1, C2) vom Schutzleiter (PE) angesteuert wird und bei Überschreitung eines vorgebbaren Schwellwertes ein Alarmsignal auslöst, sowie Mittel zur Auswertung des Alarmsignals.

## Beschreibung

Die Erfindung betrifft eine Schaltungsanordnung zur Erdungsüberwachung und zum Schutz vor gefährlichen Körperströmen, insbesondere für Geräte mit vorgeschriebenem Potentialausgleich in TT-Netzen.

Dem Schutz vor gefährlichen Körperströmen wird bei elektrotechnischen Geräten und Anlagen stets höchste Priorität eingeräumt. Eine direkte Einwirkung des Stromes, welche eine Gefährdung eines Menschen herbeiführen kann, kommt zustande, wenn der menschliche Körper in einen Stromkreis gelangt und Strom leitet. Die Höhe des Stromes hängt dabei von der Quellenspannung und dem gesamten Widerstand des Stromkreises ab, d.h. dem Widerstand des menschlichen Körpers und dem Widerstand des äußeren Stromweges. Für die Wirkung des elektrischen Stromes auf den menschlichen Körper sind Faktoren wie Stromstärke, Stromweg durch den Körper, Zeitdauer des Stromdurchgangs, Stromart und Frequenz von Bedeutung.

Damit beim Betrieb einer elektrischen Anlage keine Personen zu Schaden kommen, sind zur Verhütung von Unfällen Schutzmaßnahmen vorgesehen. Der Verband Deutscher Elektrotechniker hat dazu in seinen rechtsverbindlichen Bestimmungen (VDE-Bestimmungen) Schutzmaßnahmen zwingend vorgesehen. Ein Beispiel für solche elektrische Anlagen, bei welchen besonders hohe Anforderungen an den Schutz vor gefährlichen Körperströmen gestellt werden, sind solche Elektroanlagen, welche mit Feuchtigkeit in Berührung gelangen. Dies sind z.B. Einrichtungen in Bädern oder auch elektrische Anlagen, welche in Schwimmbädern installiert sind und daher von vornherein besondere Anforderungen an Sicherheitseinrichtungen stellen. Eine solche Einrichtung kann etwa ein Sprudelbad bzw. Whirlpool darstellen.

Für elektrische Anlagen im allgemeinen und die im vorangehenden beschriebenen im besonderen wurden unter anderem folgende Maßnahmen durch Richtlinien festgelegt:
- Schutzleiteranschluß (PE) für alle Metallteile, insbesondere solche, die mit Wasser in Berührung kommen,
- Potentialausgleich parallel zum Schutzleiteranschluß,
- Fehlerstrom-Schutzeinrichtungen (FI-Schutzschalter) in der Versorgungsleitung bzw. Netzphase,
- Anforderungen, alle berührbaren Teile mit Schutzkleinspannung zu betreiben.

Vom Hersteller einer solchen elektrischen Anlage kann jedoch lediglich die letztgenannte Anforderung sichergestellt werden, wohingegen die ersten drei Anforderungen in der Regel in der Verantwortung des die elektrische Anlage anschließenden Installateurs liegen.

Wie die Vergangenheit gezeigt hat, ist gerade dieser Aspekt kritisch, da es sich bei den Installateuren auch um Nicht-Fachleute handeln kann, die mit den einschlägigen Schutzmaßnahmen nicht vertraut sind. So können beispielsweise bei Wartungsarbeiten elektrische Verbindungen gelöst werden und beim anschließenden Wiederanschluß können Vertauschungen und Fehler auftreten. Insbesondere können vorgesehene Schutzmaßnahmen dadurch außer Kraft gesetzt werden, so daß in einem Fehlerfall kein ausreichender Schutz vor gefährlichen Körperspannungen mehr gewährleistet werden kann.

Aufgabe der vorliegenden Erfindung ist es daher, eine Schaltungsanordnung zu schaffen, welche eine Erdungsüberwachung und somit einen Schutz vor gefährlichen Körperströmen unabhängig von einem eventuell falsch vorgenommenen elektrischen Anschluß gewährleistet. Dies gilt insbesondere für solche Geräte mit vorgeschriebenem Potentialausgleich in TT-Netzen (Netze, bei denen die Erdungsbedingungen der speisenden Stromquelle eine direkte Erdung des Sternpunktes erfordern und die Erdungsbedingungen der Körper der elektrischen Anlage eine direkte Erdung der Körper vorsehen; siehe dazu Meister, H.: Elektrotechnische Grundlagen 1, Vogel-Verlag Würzburg, 8.Auflage, 1989, Seite 298). Die Schaltungsanordnung gemäß der vorliegenden Erfindung ermöglicht es, permanent den Anschluß eines Schutzleiters bzw. Potentialausgleiches zu überprüfen und im Fehlerfall ein Warnsignal zur Auswertung bereitzustellen.

Diese Aufgabe wird durch eine Schaltungsanordnung mit folgenden Elementen gelöst:
- 1.1: ein Schutzleiter ist installationsseitig mit einem Nullleiter elektrisch verbunden,
- 1.2: der Potentialausgleich ist mit Erdpotential verbunden,
- 1.3: es sind Kondensatoren vorgesehen, welche zwischen dem Schutzleiter und dem Nulleiter sowie zwischen dem Schutzleiter und einem Phasenleiter so angeordnet sind, daß sie im Gefährdungsfall einen kapazitiven Spannungsteiler bilden,
- 1.4: es ist ein Überwachungsglied vorgesehen, das über den kapazitiven Spannungsteiler vom Schutzleiter angesteuert wird und bei Überschreitung eines vorgebbaren Schwellwertes ein Alarmsignal auslöst,
- 1.5: es sind Mittel zur Auswertung des Alarmsignals vorgesehen.

In einer ersten vorteilhaften Ausgestaltung der Schaltungsanordnung gemäß der vorliegenden Erfindung werden solche Kondensatoren eingesetzt, die eine besonders große Sicherheit gegen Durchschläge und Überschläge im Dielektrikum besitzen und eine wirksame Spannungsbegrenzung bei hoher Sicherheit herbeiführen. Dies wird durch folgendes weiteres Merkmal erreicht:
- 2.1: die Kondensatoren sind als Y-Kondensatoren ausgeprägt.

In einer weiteren vorteilhaften Ausgestaltung der Schaltungsanordnung gemäß der vorliegenden Erfindung wird erreicht, daß das Überwachungsglied im Bereich eines für dieses Überwachungsglied zulässigen Spannungsbereiches sicher betrieben werden kann. Dies wird durch folgendes besonders preisgünstiges und einfaches Merkmal erreicht:
- 3.1: das Überwachungsglied wird über einen auf den kapazitiven Spannungsteiler folgenden Widerstandsteiler angesteuert.

In einer weiteren vorteilhaften Ausgestaltung der Schaltungsanordnung gemäß der vorliegenden Erfindung wird erreicht, daß hochfrequente Spannungen am Eingang des Überwachungsgliedes unterdrückt werden und auftretende Spannungsspitzen, welche beispielsweise durch Netzschwankung verursacht werden können, sicher begrenzt werden. Dies wird durch folgende weitere Merkmale erreicht:
- 4.1: am Eingang des Überwachungsglieds ist ein Tiefpaßfilter vorgesehen,
- 4.2: am Eingang des Überwachungsglieds ist ein Spannungsbegrenzer vorgesehen.

In einer weiteren vorteilhaften Ausgestaltung der Schaltungsanordnung gemäß der vorliegenden Erfindung wird erreicht, daß das Überwachungsglied auf besonders einfache und preisgünstige Art und Weise realisiert werden kann und darüber hinaus auf ebenso einfache Weise ein entsprechender Schwellwert zur Auslösung eines Alarmsignales mit einfachen und preisgünstigen Mitteln erreicht werden kann. Dies wird durch folgendes Merkmal erreicht:
- 5.1: das Überwachungsglied wird durch einen Komparator gebildet, dem über einen Spannungsteiler ein Schwellwert vorgebbar ist.

In einer weiteren vorteilhaften Ausgestaltungen der Schaltungsanordnung gemäß der vorliegenden Erfindung wird erreicht, daß ein eventuell auftretendes Fehlersignal- bzw. Alarmsignal nicht im Rhythmus der Netzfrequenz geschaltet, sondern ein konstantes Fehlersignal- bzw. Alarmsignal bereitgestellt wird. Darüber hinaus wird der Signalverlauf des bereitgestellten Ausgangssignales auf einen gut weiter zu verarbeitenden Rechtecksignalpegel gebracht. Dies wird durch folgendes weiteres Merkmal erreicht.
- 6.1: das Ausgangssignal des Komparators ist über ein Zeitglied sowie ein Mittel zur Formung von Rechtecksignalen stabilisiert.

In einer weiteren vorteilhaften Ausgestaltung der Schaltungsanordnung gemäß der vorliegenden Erfindung wird erreicht, daß auch im fehlerlosen Betrieb die Funktionstüchtigkeit der Schaltungsanordnung durch entsprechende Auswertemittel ständig überprüft werden kann, was die Sicherheit der Schaltungsanordnung weiter verbessert. Dies wird durch das folgende weitere Merkmal herbeigeführt:
- 7.1: es sind Mittel zur Netztaktsynchronisierung vorgesehen, denen der Phasenleiter als Eingangssignal dient und die ein dynamisch wechselndes netzsynchrones Ausgangssignal erzeugen, welches zur Überwachung der Funktionstüchtigkeit der Schaltungsanordnung dient.

In einer weiteren vorteilhaften Ausgestaltung der Schaltungsanordnung gemäß der vorliegenden Erfindung wird eine Möglichkeit geschaffen, die bei vorangehenden vorteilhaften Ausgestaltungen der vorliegenden Erfindung zum Einsatz gelangenden Mittel mit besonders preisgünstigen Bauteilen und somit besonders wirtschaftlich zu realisieren. Desweiteren wird die für diese Bauteile erforderliche Versorgungsspannung auf besonders einfache Weise zur Verfügung gestellt. Dies wird durch die folgende Weiterentwicklung herbeigeführt:
- 8.1: der Komparator, das Mittel zur Formung von Rechtecksignalen sowie Teile der Mittel zur Netztaktsynchronisierung sind als Operationsverstärker ausgestaltet, deren Versorgungsspannung über entsprechende Mittel aus der Phasenspannung abgeleitet ist.

In einer weiteren vorteilhaften Ausgestaltung der Schaltungsanordnung gemäß der vorliegenden Erfindung wird die Sicherheit der Schaltungsanordnung weiter erhöht und damit deren Einsatzbereich vergrößert. Dies wird durch folgendes weiteres Merkmal erreicht:
- 9.1: das Alarmsignal ist über eine Potentialtrennung mit den Mitteln zur Auswertung dazu verbunden.

In einer weiteren vorteilhaften Ausgestaltung der Schaltungsanordnung gemäß der vorliegenden Erfindung wird erreicht, daß ein vorhandenes Mittel zur Potentialtrennung für mehrere Signale gemeinsam genutzt werden kann und darüber hinaus eine besonders einfache Verarbeitung von Alarmsignal und Überwachungssignal auf die Funktionstüchtigkeit durch eine besonders trickreiche Verschaltung dieser Signale erreicht wird. Dies wird durch folgendes weiteres Merkmal herbeigeführt:
- 10.1: das Ausgangssignal zur Überwachung der Funktionstüchtigkeit der Schaltungsanordnung und das Alarmsignal sind miteinander über eine Wired-UND-Schaltung gekoppelt und das resultierende Signal ist über eine Potentialtrennung mit den Mitteln zur Auswertung dazu verbunden.

In einer weiteren vorteilhaften Ausgestaltung der Schaltungsanordnung gemäß der vorliegenden Erfindung wird die der Erfindung zugrundeliegende Aufgabe für einen mit besonders hohen Sicherheitsanforderungen belegten Einsatzbereich gelost. Dies wird durch folgendes Merkmal erreicht:
- 11.1: die Schaltungsanordnung ist einem elektrisch betriebenen Sprudelbad vorschaltbar.

In einer weiteren vorteilhaften Ausgestaltung der Schaltungsanordnung gemäß der vorliegenden Erfindung wird erreicht, daß eine Signalisierung im Fehlerfall auf einfache und sichere Art und Weise erreicht wird, so daß betroffene Personen schnell auf die Gefährdung hingewiesen werden. Dies wird durch folgendes weiteres Merkmal herbeigeführt:
- 12.1: die Mittel zur Auswertung des Alarmsignals besitzen ein Leuchtmittel zur Signalisierung, insbesondere eine Leuchtdiode.

Weitere Vorteile und erfinderische Einzelheiten ergeben sich aus der nachfolgenden Beschreibung eines vorteilhaften Ausführungsbeispiels, anhand der Figuren und in Verbindung mit den Unteransprüchen. Dabei zeigen im einzelnen:
- FIG 1: Prinzipskizze einer Schaltungsanordnung zur Erdungsüberwachung gemäß der vorliegenden Erfindung und
- FIG 2: Blockschaltbild einer vorteilhaften Realisierung der Schaltungsanordnung zur Erdungsüberwachung gemäß der vorliegenden Erfindung.

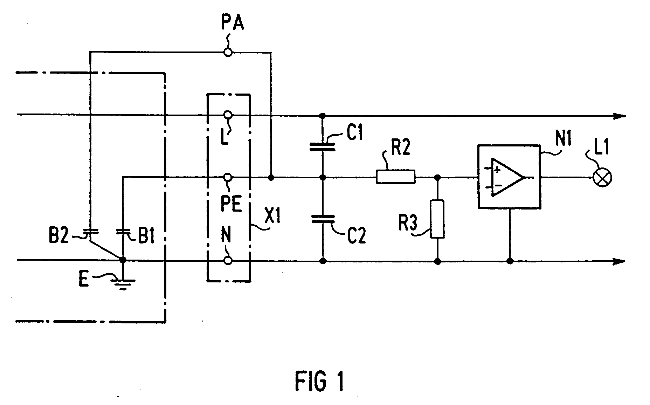

In der Darstellung gemäß FIG 1 ist eine Prinzipskizze einer Schaltungsanordnung zur Erdungsüberwachung und zum Schutz vor gefährlichen Körperströmen gezeigt, welche insbesondere für Geräte mit vorgeschriebenem Potentialausgleich in TT-Netzen geeignet ist. Im folgenden vorteilhaften Ausführungsbeispiel wird eine solche Schaltungsanordnung zum Schutz für Sprudelbadgeräte, welche auch als Whirlpool bezeichnet werden, beschrieben. Der Einsatz einer Schaltungsanordnung gemäß der vorliegenden Erfindung läßt sich ohne Probleme auch auf andere Anwendungsgebiete übertragen, an die ähnliche hohe Sicherheitsanforderungen gestellt werden.

Fur Sprudelbadgeräte ist eine feste Installation vorgeschrieben. Der Übergang findet dazu in einer in der Darstellung gemäß FIG 1 mit X1 bezeichneten Anschlußklemme statt. An diese Anschlußklemme sind ein Phasenleiter L, ein Schutzleiter PE und ein Nulleiter N gefuhrt. Desweiteren ist ein Potentialausgleich PA vorgesehen, der über eine separate Leitung mit Erdpotential E verbunden ist. Der Schutzleiter PE wird, wie es für in dem Ausführungsbeispiel zugrundegelegten TT-Netzen vorgesehen ist, installationsseitig mit dem Nulleiter N verbunden. Desweiteren ist der Nulleiter N installationsseitig ebenfalls mit Erdpotential E verbunden.

Mögliche Fehlerfälle können z.B. dadurch eintreten, daß zum einen in der Verbindungsleitung zwischen Schutzleiter PE und Nulleiter N oder zum anderen in der separaten Bindungsleitung zwischen Potentialausgleich PA und Erdpotential E Bruchstellen auftreten. Eine Solche Möglichkeit ist in der Darstellung gemäß FIG 1 durch zwei mögliche Bruchstellen B1 und B2, welche durch waagrechte Striche angedeutet sind, gezeigt.

Zwischen Schutzleiter PE und Phasenleiter L sowie zwischen Schutzleiter PE und Nulleiter N ist jeweils ein X-Kondensator C1 und C2 geschaltet. Kommt es nun zu einem der durch B1 und B2 angedeuteten Fehlerfälle oder zu einem anderen Fehlerfall mit gleicher Auswirkung, bei dem weder der Schutzleiter PE noch der Potentialausgleich PA mehr mit Erdpotential E verbunden sind, so entsteht über die X-Kondensatoren C1 und C2 ein kapazitiver Spannungsteiler. Diese Spannung wird über einen weiteren Widerstandsteiler, welcher durch zwei Widerstände R2 und R3 gebildet wird, einer Überwachungslogik N1 zugeführt, die bei Überschreitung einer bestimmten vorgebbaren Spannung ein Alarmsignal auslöst. Dieses Alarmsignal wird beispielsweise durch das Blinken einer Lampe L1 oder auch einer Leuchtdiode signalisiert. Die Auswertung des Alarmsignales kann jedoch auch auf beliebige andere Art und Weise, insbesondere auf akustische Art und Weise oder durch weitere Stillsetzungs-, Nothalt- oder andere Schutzmaßnahmen ausgewertet werden.

Im Normalfall wird die Spannung am Kondensator C1 durch die Brückung zwischen dem Schutzleiter PE und den Nulleitern N sehr niedrig gehalten und somit kein Alarm ausgelöst. Ein Vorteil der in der Darstellung gemäß FIG 1 beschriebenen Schaltungsanordnung gemäß der vorliegenden Erfindung ist dabei auch, daß diese Schaltung auch dann in Fehlerfällen sicher reagiert, wenn der Phasenleiter L und der Nulleiter N vertauscht worden sind.

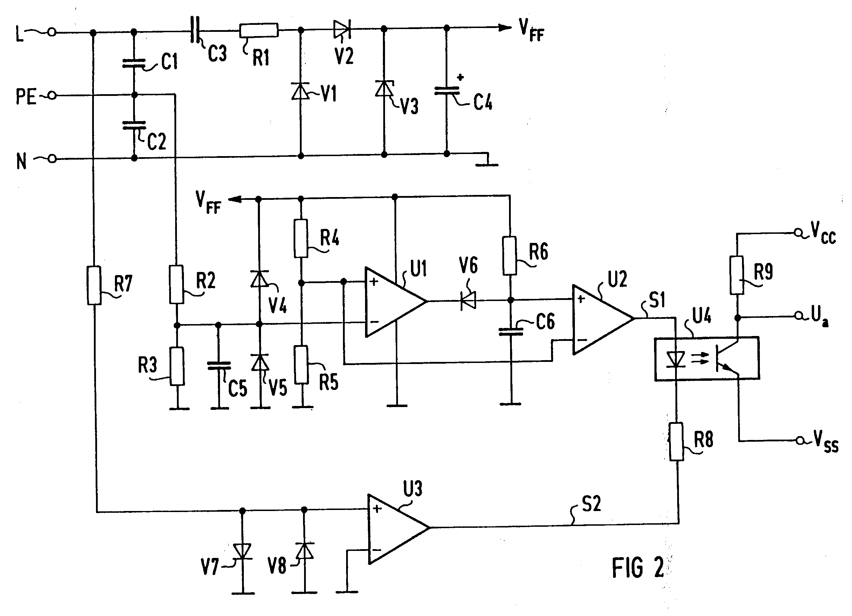

In der Darstellung gemäß FIG 2 ist ein Blockschaltbild der Schaltungsanordnung zur Erdungsüberwachung und zum Schutz vor gefährlichen Körperströmen gemäß der vorliegenden Erfindung gezeigt, welches eine besonders vorteilhafte Realisierung vor allem des Überwachungsgliedes N1 mit den dazu erforderlichen elektrischen Bauteilen zeigt. Eingangsseitig sind wiederum die durch die in FIG 1 dargestellte Anschlußklemme X1 vorgegebenen Anschlüsse für den Phasenleiter L, der Schutzleiter PE und den Nulleiter N vorgegeben. Ebenso sind, wie bereits vorangehend dargestellt, zwei Y-Kondensatoren C1 und C2 als möglicher kapazitiver Spannungsteiler zwischen Schutzleiter PE und Nulleiter N sowie Schutzleiter PE und Phasenleiter L geschaltet. Diese wirken daneben auch als Entstörkondensatoren für die Whirlpool-Steuerung. Desweiteren ist eine Schaltung mit den Elementen eines Kondensators C3, einem Widerstand R1, zwei Dioden V1 und V2 sowie eine Zenerdiode V3 und einem Pufferkondensator C4 gezeigt, welche aus der Netzspannung eine niedrigere Spannung V_{FF}, die beispielsweise 5V beträgt, ableitet. Der Kondensator C3, welcher in Serie zum Widerstand R1 an den Phasenleiter L geschaltet ist, wirkt mit R1 als Filterglied. Die Dioden V1 und V2 bewirken eine Gleichrichtung und die Zenerdiode V3 erzeugt die durch ihren Nennwert vorgegebene Spannung, welche über ihr abfällt, und die über den Stabilisierungskondensator C4, bevorzugterweise einem Elektrolytkondensator, stabilisiert wird. Die Spannung V_{FF} dient als Vorsorgungsspannung für die Überwachungseinheit und die

Über einen Spannungsteiler mit den Widerständen R2 und R3 wird die Spannung zwischen dem Schutzleiter PE und dem Nullleiter N gemessen. Ein parallel zum Widerstand R3 geschalteter und mit Masse verbundener Kondensator C5 wirkt dabei als Tiefpaßfilter und unterdrückt hochfrequente Spannungen, welche im Netz auftreten können. Desweiteren ist ein weiterer Spannungsteiler mit den Widerständen R4 und R5 gezeigt, welcher zwischen die Versorgungsspannung V_{FF} und Masse geschaltet ist. Ein als Komparator U1 geschalteter Operationsverstärker vergleicht die Spannung am Spannungsteiler mit R2 und R3 mit dem Spannungswert am Spannungsteiler mit den Widerständen R4 und R5. Dazu ist der negierte Eingang mit dem Spannungsteiler R2 und R3, der nichtnegierte Eingang mit dem Spannungsteiler R4 und R5 verbunden. Zusätzlich ist dem negierten Eingang noch ein Spannungsbegrenzer vorgeschaltet, welcher durch zwei Dioden V4 und V5 gebildet wird. Dazu ist eine der Dioden vom Spannungsteiler R2 und R3 in Sperrichtung gegen Masse geführt, die andere in Durchlaßrichtung zur Versorgungsspannung V_{FF}.

Der als Komparator U1 geschaltete Operationsverstärker schaltet für den Fall, daß der Spannungswert am Spannungsteiler R2 und R3 höher ist als am Spannungsteiler R4 und R5 am Ausgang auf Low-Potential. An den Ausgang des Komparators U1 ist ein Zeitglied geschaltet, welches aus Diode V6, einem Kondensator C6 und einem Widerstand R6 gebildet ist. Dazu ist die Diode V6 mit der Kathode an den Ausgang des Komparators U1 geschaltet, die Anode ist über den Kondensator C6 mit Masse und über den Widerstand R6 mit der Versorgungsspannung V_{FF} verbunden. Eine erkannte Störung, welche durch das Low-Potential am Ausgang des Komparators U1 signalisiert wird, wird dadurch so verlängert, daß das Fehlersignal nicht im Rhythmus der Netzfrequenz, in der Regel 50 Hz, schaltet, sondern ein konstantes Signal erzeugt wird. Dazu wird die Zeitkonstante des Zeitgliedes durch die Bemessung des Widerstandes R6 und des Kondensators C6 so vorgenommen, daß ein entsprechender Signalimpuls im Falle eines Netzes mit 50 Hz Frequenz um mindestens 20 msec verlängert wird. Auf das Zeitglied folgt ein weiterer Operationsverstärker U2, welcher aus dem exponentiellen Signalverlauf des Zeitglieds wieder ein sauberes Rechtecksignal formt. Dazu ist dessen nichtinvertierender Eingang mit der Anode der Diode V6 verbunden, der invertierende Eingang ist auf den nichtinvertierenden Eingang des Operationsverstärkers des Komparators U1 geführt. Am Ausgang des Operationsverstärkers U2 steht somit das Alarmsignal S1 zur Verfügung.

Unabhängig davon erfolgt eine Netztaktsynchronisierung durch entsprechende Schaltmittel R7, V7, V8 und einen Operationsverstärker U3. Über einen Widerstand R7 wird die Phasenspannung am Phasenleiter L abgegriffen und über zwei gegenpolig geschaltete mit Masse verbundene Dioden V7 und V8 an den nicht invertierenden Eingang des Operationsverstärkers U3 geführt. Die beiden gegenpolig geschalteten Dioden V7 und V8 sind zwischen nichtinvertierenden Eingang und Masse geschaltet und begrenzen die Eingangsspannung unabhängig von deren Polarität auf ein für den Operationsverstärker geeignetes Maß zwischen -0,6 V und +0,6 V. Der invertierende Ausgang des Operationsverstärkers U3 ist auf Masse gelegt. Das Ausgangssignal des Operationsverstärkers S2 führt ein netzsynchrones Rechtecksignal, welches über einen weiteren Widerstand R8 an einen Optokoppler U4 geführt ist.

Das Alarmsignal S1 und das netzsynchrone Signal S2 sind im Stil einer Wired-UND-Schaltung verschaltet, indem das Alarmsignal S1 an den Anodeneingang und das über den Widerstand R8 geführte netzsynchrone Signal S2 an den Kathodeneingang eines Optokopplers U4 geführt ist. Über einen weiteren Widerstand R9 wird ein im Fehlerfall anliegendes Alarmsignal an die Whirlpool-Steuerung, welche der besseren Übersichtlichkeit halber nicht gezeigt ist, potentialfrei übertragen. Dazu ist auf Seiten der Whirlpool-Steuerung eine eigene Versorgungsspannung V_{CC} und V_{SS} vorgesehen.

Im fehlerfreien Zustand liegt High-Potential am Ausgang S2 an. Der Operationsverstärker U3 erzeugt am Ausgang S2 ein netzsynchrones Rechtecksignal. Durch die Wired-UND-Verknüpfung führt ein auf Seiten der Whirlpool-Steuerung am Ausgang des Optokopplers U4 anliegender Ausgangswert Uₐ ebenfalls ein Rechtecksignal. Dieses Signal wird von der Whirlpool-Steuerung ausgewertet und besitzt gegenüber einer statischen Signalübertragung den entscheidenden Vorteil, daß mit einem dynamisch wechselnden Signal, wie es das netzsynchrone Rechtecksignal S2 darstellt, die Funktionstüchtigkeit der Schaltungsanordnung zu jedem Zeitpunkt durch die auf Seiten der Whirlpool-Steuerung vorgesehenen und der besseren Übersichtlichkeit halber nicht gezeigten Mittel zur Auswertung des Alarmsignales überwacht werden kann. Darüber hinaus eröffnet sich dadurch die Möglichkeit, die Phasenlage der Netzspannung zu erfassen und damit auf Seiten der Whirlpool-Steuerung Phasenanschnittssteuerungs-Schaltungen zu realisieren.

Im Fehlerfall, beispielsweise durch die in der Darstellung gemäß FIG 1 gezeigten Leitungsbrüche B1 und B2, liegt eine Wechselspannung zwischen dem Schutzleiter PE und dem Nullleiter N, welche mindestens die Größenordnung der halben Netzspannung aufweist. In diesem Fall nimmt der Alarmausgang S2 Low-Potential an, wodurch der Ausgang Uₐ auf Seiten der Whirlpool-Steuerung aufgrund der negierenden Wirkung der Beschaltung des Optokopplers U4 High-Potential annimmt. Solange ein fehlerfreier Zustand vorherrscht und das Alarmsignal S1 auf High-Potential liegt, gelangt somit das netzsynchrone Rechtecksignal S2 aufgrund der UND-Verbindung negiert an den Ausgang Uₐ. Tritt hingegen ein Fehler auf, so wechselt der Zustand des Alarmsignales S1 auf Low-Potential und aufgrund der UND-Verknüpfung gelangt das netzsynchrone Rechtecksignal nicht mehr an den Ausgang Uₐ, sondern dieser führt aufgrund der Negierung High-Potential, was den Fehlerfall signalisiert. Eine entsprechende Überwachung dieses Ausgangssignales Uₐ auf Seiten der Whirlpool-Steuerung können dann geeignete Schutzmaßnahmen eingeleitet werden.

## Patentansprüche

1. Schaltungsanordnung zur Erdungsüberwachung und zum Schutz vor gefährlichen Körperströmen, insbesondere für Geräte mit vorgeschriebenem Potentialausgleich in TT-Netzen, mit folgenden Elementen:
1.1 ein Schutzleiter (PE) ist installationsseitig mit einem Nulleiter (N) elektrisch verbunden,
1.2 der Potentialausgleich (PA) ist mit Erdpotential (E) verbunden,
1.3 es sind Kondensatoren (C1,C2) vorgesehen, welche zwischen dem Schutzleiter (PE) und dem Nulleiter (N) sowie zwischen dem Schutzleiter (PE) und einem Phasenleiter (L) so angeordnet sind, daß sie im Gefährdungsfall einen kapazitiven Spannungsteiler bilden,
1.4 es ist ein Überwachungsglied (N1) vorgesehen, das über den kapazitiven Spannungsteiler (C1,C2) vom Schutzleiter (PE) angesteuert wird und bei Überschreitung eines vorgebbaren Schwellwertes ein Alarmsignal auslöst,
1.5 es sind Mittel zur Auswertung des Alarmsignals vorgesehen.

2. Schaltungsanordnung nach Anspruch 1, mit folgendem Merkmal:
2.1 die Kondensatoren (C1,C2) sind als Y-Kondensatoren ausgeprägt.

3. Schaltungsanordnung nach Anspruch 1 oder 2, mit folgendem Merkmal:
3.1 das Überwachungsglied (N1) wird über einen auf den kapazitiven Spannungsteiler (C1,C2) folgenden Widerstandsteiler (R2,R3) angesteuert.

4. Schaltungsanordnung nach einem oder mehreren der voranstehenden Ansprüche, mit folgenden Merkmalen:
4.1 am Eingang des Überwachungsglieds (N1) ist ein Tiefpaßfilter (C5) vorgesehen,
4.2 am Eingang des Überwachungsglieds (N1) ist ein Spannungsbegrenzer (V4, V5) vorgesehen.

5. Schaltungsanordnung nach einem oder mehreren der voranstehenden Ansprüche, mit folgendem Merkmal:
5.1 das Überwachungsglied (N1) wird durch einen Komparator (U1) gebildet, dem über einen Spannungsteiler (R4,R5) ein Schwellwert vorgebbar ist.

6. Schaltungsanordnung nach einem oder mehreren der voranstehenden Ansprüche, mit folgenden Merkmalen:
6.1 das Ausgangssignal des Komparators (U1) ist über ein Zeitglied (V6,R6,C6) sowie ein Mittel (U2) zur Formung von Rechtecksignalen stabilisiert.

7. Schaltungsanordnung nach einem oder mehreren der voranstehenden Ansprüche, mit folgenden Merkmalen:
7.1 es sind Mittel zur Netztaktsynchronisierung (R7,V7,V8,U3) vorgesehen, denen der Phasenleiter (L) als Eingangssignal dient und die ein dynamisch wechselndes netzsynchrones Ausgangssignal (S2) erzeugen, welches zur Überwachung der Funktionstüchtigkeit der Schaltungsanordnung dient.

8. Schaltungsanordnung nach einem oder mehreren der Ansprüche 5 bis 7, mit folgenden Merkmalen:
8.1 der Komparator (U1), das Mittel (U2) zur Formung von Rechtecksignalen sowie Teile (U3) der Mittel zur Netztaktsynchronisierung (R7,V7,V8,U3) sind als Operationsverstärker ausgestaltet, deren Versorgungsspannung über entsprechende Mittel (C3,R1,V1,V2,C4) aus der Phasenspannung abgeleitet ist.

9. Schaltungsanordnung nach einem oder mehreren der voranstehenden Ansprüche, mit folgenden Merkmalen:
9.1 das Alarmsignal (S2) ist über eine Potentialtrennung (U4) mit den Mitteln zur Auswertung dazu verbunden.

10. Schaltungsanordnung nach einem oder mehreren der voranstehenden Ansprüche, mit folgenden Merkmalen:
10.1 das Ausgangssignal (S2) zur Überwachung der Funktionstüchtigkeit der Schaltungsanordnung und das Alarmsignal (S1) sind miteinander über eine Wired-Und-Schaltung gekoppelt und das resultierende Signal ist über eine Potentialtrennung (U4) mit den Mitteln zur Auswertung dazu verbunden.

11. Schaltungsanordnung nach einem oder mehreren der voranstehenden Ansprüche, mit folgendem Merkmal:
11.1 die Schaltungsanordnung ist einem elektrisch betriebenen Sprudelbad vorschaltbar.

12. Schaltungsanordnung nach einem oder mehreren der voranstehenden Ansprüche, mit folgendem Merkmal:
12.1 die Mittel zur Auswertung des Alarmsignals besitzen ein Leuchtmittel (L1) zur Signalisierung, insbesondere eine Leuchtdiode .
